(19) Europäisches Patentamt
European Patent Office
Office européen des brevets

(11) **EP 2 098 878 B1**

(12) **EUROPEAN PATENT SPECIFICATION**

(45) Date of publication and mention
of the grant of the patent:
**03.06.2015 Bulletin 2015/23**

(51) Int Cl.:
***G01R 31/36*** *(2006.01)*

(21) Application number: **09003142.8**

(22) Date of filing: **04.03.2009**

(54) **Battery service life estimation using a regression model and state estimation**

Schätzung der Batterielebensdauer, mittels eines Regressionsmodels und Zustandsschätzungstechnik

Estimation de la durée de vie d'une batterie, utilisant un modèle de régression et une techniques d'estimation d'état

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(30) Priority: **04.03.2008 US 41801**

(43) Date of publication of application:
**09.09.2009 Bulletin 2009/37**

(73) Proprietor: **Eaton Corporation
Cleveland, Ohio 44114-2584 (US)**

(72) Inventor: **Burgess, Webb Lewis
Raleigh
North Carolina 27609 (US)**

(74) Representative: **Wagner, Karl H.
Wagner & Geyer Partnerschaft
Patent- und Rechtsanwälte
Gewürzmühlstrasse 5
80538 München (DE)**

(56) References cited:
**US-A1- 2002 130 637      US-A1- 2006 250 137
US-B1- 6 924 622      US-B2- 7 199 557**

- **WEBB L. BURGESS: "An analysis of float service
life test data of VRLA batteries", JOURNAL OF
POWER SOURCES, vol. 75, 1998, pages 28-35,
XP002720974,**
- **COLEMAN M ET AL: "State of Health
Determination: Two Pulse Load Test for a VRLA
Battery", POWER ELECTRONICS SPECIALISTS
CONFERENCE, 2006. PESC '06. 37TH IEEE JEJU,
KOREA 18-22 JUNE 2006, PISCATAWAY, NJ,
USA,IEEE, 18 June 2006 (2006-06-18), pages 1-6,
XP010945095, DOI: 10.1109/PESC.2006.1711801
ISBN: 978-0-7803-9716-3**

**Description**

**BACKGROUND OF THE INVENTION**

The invention relates to power supply systems, methods and computer program products for operation thereof and, more particularly, to methods, apparatus and computer program products for battery service life estimation.

In some battery applications, such as in uninterruptible power supply (UPS) systems, a battery may be operated in a "float service" mode. In such applications, the battery typically is infrequently discharged, with discharges being separated by extended periods in which the battery is float charged at relatively low charging rates.

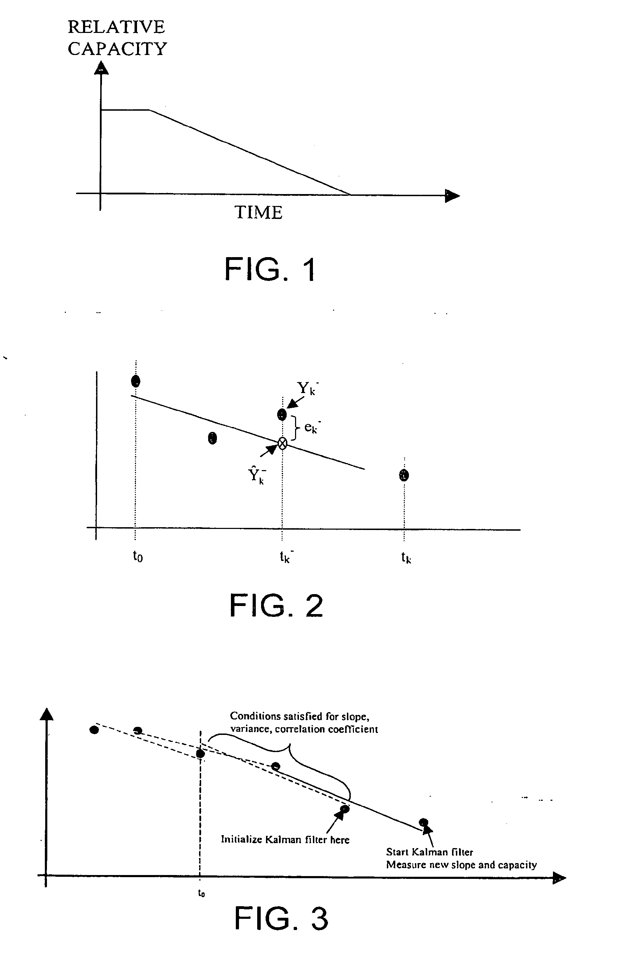

The float service life of a battery may be characterized as being divided into two distinct periods, as depicted in Fig. 1. The first period is a time during which the loss of capacity over time is generally small. This can be thought of as a threshold or guarantee time. The second period may be characterized by a much more rapid decrease of capacity over time and continues until there is no useable capacity remaining. The length of the first period may be determined by several factors, such as the discharge rate used in a test or application. The lower the discharge rate, typically the longer will be the time of this portion of float service life. The duration of the second period may generally be governed more by the battery design and the particular mechanism controlling life. Such a model of battery float service life is described in "An analysis of float service life test data of VRLA batteries" by Webb L. Burgess, Journal of Power Sources 75 (1998), pp. 28-35.

In float service applications, such as UPS applications, it may be desirable to generate a prediction of battery service life, *e.g.,* a prediction of when the capacity of a battery will fall below a certain predetermined level due to various degradation processes that are acting on the battery. Such a prediction may be useful, for example, for purposes of capital expenditure planning and/or preventive maintenance.

Techniques have been proposed to estimate service life of batteries. Techniques for charge capacity and reserve life estimation are described, for example, in U.S. Patent No. 6,924,622 to Anbuky et al. and U.S. Patent No. 7,199,557 to Anbuky et al. Furthermore, reference is made to US 2002 130 637 A1, which uses a Kalman filter in determining parameters of a battery utilized within a framework for estimating the capacity of the battery.

**SUMMARY OF THE INVENTION**

In accordance with the invention, a method of estimating service life of a battery as set forth in claim 1, an apparatus of claim 5 and a computer-readable medium as set forth in claim 7 are provided. Further embodiments are inter alia disclosed in the dependent claims. In particular, a set of measures of capacity of the battery is generated responsive to a series of discharges of the battery. A prediction of service life is generated from the measure of capacity using a Kalman filter. Generating a prediction of service life from the measure of capacity using a Kalman filter is preceded by generating a regression model, such as a straight-line model, that relates battery capacity to time based on the set of measures of battery capacity. Generating a prediction of service life from the measure of capacity using a Kalman filter includes initializing the Kalman filter responsive to the regression model meeting a predetermined criterion, for example, when a straight-line regression model has predetermined slope, variance and correlation coefficient values.

Initializing the Kalman filter responsive to the regression model meeting a predetermined criterion may include initializing the Kalman filter with an initial condition generated from the regression model. The methods may further include generating a series of measures of capacity of the battery responsive to a series of discharges of the battery following initialization of the Kalman filter and generating a series of predictions of service life from the series of measures of capacity using the Kalman filter. Generating a measure of capacity of the battery responsive to a discharge of the battery may include determining a time required to discharge the battery to a predetermined voltage and generating the measure of capacity based on the determined discharge time.

According to further embodiments of the present invention, service life of a battery is estimated by generating a set of measures of battery capacity responsive to a series of discharges of the battery, generating a regression model that relates battery capacity to time based on the set of measures of battery capacity, initializing a predictive state estimator of future battery capacity responsive to the regression model meeting a predetermined criterion and generating a prediction of service life using the state estimator. The regression model may include a straight-line regression model, and the state estimator may include a deterministic model of battery capacity degradation, a probabilistic model of battery capacity degradation an/or an adaptive model of battery capacity degradation. In particular, the state estimator is a Kalman filter. The state estimator may be initialized with an initial condition generated according to the regression model.

Further embodiments of the present invention provide an apparatus including a battery service life estimator circuit configured to receive a measure of capacity of a battery and to generate a prediction of service life from the measure of capacity using a Kalman filter. The battery service life estimator circuit may be configured to generate a set of measures of capacity of the battery corresponding to a series of discharges of the battery, to generate a regression model that relates battery capacity to time based on the set of measures of battery capacity and to initialize the Kalman filter responsive to the regression model meeting a predetermined criterion. The apparatus may further include a battery capacity measurement circuit configured to generate the measure of battery capacity responsive to the discharge of the battery. For example, the battery capacity measurement circuit may be configured to determine a time required to discharge the battery to a predetermined voltage and to generate the measure of capacity based on the determined discharge time. In still further embodiments, the apparatus may further include an uninterruptible power supply (UPS) circuit configured to be coupled to the battery and to charge and discharge the batter and a battery capacity measurement circuit configured to generate the measure of capacity of the battery responsive to a discharge of the battery by the UPS circuit.

Additional embodiments of the present invention provide an apparatus including a battery service life estimator circuit configured to receive a set of measures of battery capacity for a battery, to generate a regression model that relates battery capacity to time based on the set of measures of battery capacity, to initialize a state estimator of future battery capacity responsive to the regression model meeting a predetermined criterion and to generate a prediction of service life using the state estimator. The apparatus may further include an uninterruptible power supply (UPS) configured to be coupled to the battery and to charge and discharge the battery and a battery capacity measurement circuit configured to generate the measure of capacity of the battery responsive to a discharge of the battery by the UPS.

Still further embodiments of the present invention provide a computer-readable medium having computer program code embodied therein, the computer program code including program code configured to receive a measure of capacity of the battery and program code configured to generate a prediction of service life from the measure of capacity using a Kalman filter. Additional embodiments provide a computer-readable medium having computer program code embodied therein, the computer program code including program code configured to receive a set of measures of battery capacity corresponding to respective ones of a series of discharges of a battery, program code configured to generate a regression model that relates battery capacity to time based on the set of measures of battery capacity, program code configured to initialize a state estimator of future battery capacity responsive to the regression model meeting a predetermined criterion, and program code configured to generate a prediction of service life using the state estimator.

BRIEF DESCRIPTION OF THE DRAWINGS

FIG. 1 is diagram illustrating an exemplary battery capacity characteristic.
FIG. 2 is a diagram illustrating use of a regression model to detect acceleration of battery capacity decrease according to some embodiments of the present invention.
FIG. 3 is a diagram illustrating use of a regression model to initialize a Kalman filter according to some embodiments of the present invention.
FIG. 4 is a flowchart illustrating operations for generating a prediction of battery service life according to some embodiments of the present invention.
FIG. 5 is a flowchart illustrating operations for generating a prediction of battery service life using a state estimator initialized using a regression model according to further embodiments of the present invention.
FIG. 6 is a flowchart illustrating operations for generating a prediction of battery service life using a Kalman filter initialized using a regression model according to still further embodiments of the present invention.
FIG. 7 is a block diagram illustrating an apparatus for battery service life estimation according to some embodiments of the present invention.
FIG. 8 is a block diagram illustrating implementation of a battery service life estimator in an uninterruptible power supply (UPS) according to additional embodiments of the present invention.
FIG. 9 is a block diagram illustrating implementation of a battery service life estimator in a networked environment according to further embodiments of the present invention.

**DETAILED DESCRIPTION OF EMBODIMENTS**

Specific exemplary embodiments of the invention now will be described with reference to the accompanying drawings. This invention may, however, be embodied in many different forms and should not be construed as limited to the embodiments set forth herein; rather, these embodiments are provided so that this disclosure will be thorough and complete, and will fully convey the scope of the invention to those skilled in the art. In the drawings, like numbers refer to like elements. It will be understood that when an element is referred to as being "connected" or "coupled" to another element, it can be directly connected or coupled to the other element or intervening elements may be present. As used herein the term "and/or" includes any and all combinations of one or more of the associated listed items.

The terminology used herein is for the purpose of describing particular embodiments only and is not intended to be limiting of the invention. As used herein, the singular forms "a", "an" and "the" are intended to include the plural forms as well, unless expressly stated otherwise. It will be further understood that the terms "includes," "comprises," "including" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the specification and the relevant art and will not be interpreted in an idealized or overly formal sense unless expressly so defined herein.

As will be appreciated by one of skill in the art, the invention may be embodied as systems, methods and computer program products. Some embodiments of the invention may include hardware and/or software. Some embodiments of the invention include circuitry configured to provide functions described herein. It will be appreciated that such circuitry may include analog circuits, digital circuits, and combinations of analog and digital circuits. Some embodiments of the invention may include a computer readable medium having computer program code embodied therein, such as a semiconductor memory device (*e.g.,* static, dynamic or flash memory) or a magnetic or optical storage medium (*e.g.,* tape, compact disk, etc.) having computer program code stored therein.

Embodiments of the invention are described below with reference to block diagrams and/or operational illustrations (*e.g.*, flowcharts) of systems and methods according to various embodiments of the invention. It will be understood that each block of the block diagrams and/or operational illustrations, and combinations of blocks in the block diagrams and/or operational illustrations, can be implemented by analog and/or digital hardware, and/or computer program instructions. These computer program instructions may be provided to a processor of a general purpose computer, special purpose computer, ASIC, and/or other programmable data processing apparatus, such that the instructions, which execute via the processor of the computer and/or other programmable data processing apparatus, create means for implementing the functions/acts specified in the block diagrams and/or operational illustrations. In some implementations, the functions/acts noted in the figures may occur out of the order noted in the block diagrams and/or operational illustrations. For example, two operations shown as occurring in succession may, in fact, be executed substantially concurrently or the operations may sometimes be executed in the reverse order, depending upon the functionality/acts involved.

## Estimation of Battery Service Life

A conceptual overview of exemplary techniques for estimating battery service life will now be presented. The discussion that follows includes description of Kalman filter based techniques that may be particularly efficacious in battery float service life estimation for VRLA batteries by taking advantages of certain characteristic features associated with the typical float service life of such batteries. However, it will be appreciated that further embodiments of the present invention may also be applicable to other types of batteries, and may utilize different battery service life characteristics.

In many float service applications, such as UPS applications, an important feature of battery management is the ability to estimate the time remaining for the battery to reach end of life. According to some embodiments of the present invention, a project ahead step in a Kalman filter loop may be used to predict battery service life, *e.g.,* to estimate the remaining life of the battery. With a suitable model of the capacity degradation process during the second period of float service life described above, it may be possible, after each measurement of capacity, to predict the capacity at a specified point in the future.

In a float service life application of a valve regulated lead-acid (VRLA) battery, as a battery ages, two mechanisms, grid corrosion and loss of electrolyte, may govern the rate of degradation of capacity. According to some embodiments of the present invention, an understanding of the process by which physical measurements and, in this case, the pairs (capacity, time in float service) can be incorporated into a probabilistic setting. A potential benefit of this approach is that it may allow the methods of probability and statistics to be used to explore the data and perform analyses to determine whether any relationships exist between the measurements and. if so, if there is an underlying distribution which might adequately describe the relationship.

A sample group, of some size, of a particular manufacturer's battery may be put into the same float service application. At some interval, not necessarily periodic, the batteries may be discharged using a prescribed set of conditions (e.g., load and end voltage). The capacity (or discharge time) may be measured and recorded together with the operating time of the battery. This may be repeated until the capacity of each battery has diminished to a point where it is no longer useful. Such an exercise may produce a collection of battery capacity and operating time data for each battery.

One possible use of the data is to make some estimate of the length of the float service life of this battery model, that is, how long will the battery operate before its capacity decreases to some specified value, generally given as a percentage of the rated or initial capacity. A step in this process may be to normalize the capacity (or discharge time) measurements. One method is to divide every capacity measurement, from each battery in the sample by a reference value, chosen generally from prior test data, to be slightly larger than the largest capacity in the sample. The result will be a collection of relative capacities, $\kappa$, where $0 < \kappa < 1$.

Consider now any of the particular points in time at which the sample of batteries is discharged. There will be a range of (relative) capacities measured that correspond to the time on test when the discharges were conducted. It is helpful to think of these different capacities as being due to different ages of the battery. So a battery with a relative capacity of 0.83 may be considered to have not aged as much as another in the sample with a relative capacity of 0.79. In other words, the rates of aging may be different for these two batteries because they have both been on float for the same amount of time. Hence, one may expect the float service life of the first battery to be longer than that of the second. Continuing along this line of reasoning allows the age of the battery to be treated as a random variable.

Now it is possible to formulate the relative capacity and time on test in a probabilistic statement:

$$\kappa_i = \Pr\{L \le L_i\} = 1 - \Pr\{L > L_i\} . \qquad (1)$$

The relative capacity $\kappa_i$ equals the probability that the age of the battery, L, is less than or equal to the accumulated time on float at the ith discharge, $L_i$. The expression $\Pr\{L \le L_i\}$ is the cumulative distribution function. The remaining work is to find a distribution whose properties match those of the data collected.

In "An analysis of float service life test data of VRLA batteries" by Webb L. Burgess, Journal of Power Sources 75 (1998), pp. 28-35, the extreme value distribution was found to adequately represent the capacity degradation process. It is of the form:

$$F^{-1}(\kappa) = a_1(L\text{-}L_0) + a_0. \qquad (2)$$

where:

    i) $L_0$ is the length of the first period of the float service life;
    ii) L is the age of the battery; $L\text{-}L_0 \ge 0$;
    iii) parameters $a_1$ and $a_0$ are estimated from the data; and
    iv) $F^{-1}(\kappa)$ is the inverse distribution function, $F^{-1}(\kappa) = \ln[-\ln(1 - \kappa)]$.

The model in equation (2) defines a random process.

To design the Kalman filter, a representation of the random process in terms of a system of linear differential equations may be developed. A Kalman filter is an algorithm for obtaining a minimum mean-square error point estimate of a random process. It is a method of least squares filtering that is obtained from a state space formulation. To construct a Kalman filter, equation (2) may be recast as a system of linear differential equations.

Equation (2) is a linear equation in the variable L, with slope $a_1$ and y-intercept $a_0$. For this model let

$$y(L) = a_1(L\text{-}L_0) + a_0 . \qquad (3)$$

Letting
$x_1 = y(L)$,
$x_2 = \dot{y}(L) = \dot{x}_1$,
$\dot{x}_2 = \ddot{y}(L) = 0$,
$y(L_0) = a_0$, and
$\dot{y}(0) = a_1$,
the resulting system of linear differential equations from these operations is

$$\begin{bmatrix} \dot{x}_1 \\ \dot{x}_2 \end{bmatrix} = \begin{bmatrix} 0 & 1 \\ 0 & 0 \end{bmatrix} \begin{bmatrix} x_1 \\ x_2 \end{bmatrix} . \qquad (4)$$

The discrete version of the state transition matrix can be obtained from equation (4) and is of the form

$$\phi(\Delta t) = \begin{bmatrix} u(\Delta t) & \Delta t \\ 0 & u(\Delta t) \end{bmatrix}, \qquad (5)$$

where $u(\Delta t)$ is the unit step function.

The Kalman filter equations or loop will be listed and following these the initial conditions will be developed. Following initialization the sequence of steps is executed in the order shown. After the last step the process is repeated using the quantities from the project ahead step as inputs to start the loop again.

Start Filter:

1) Compute Kalman Gain:

$$K_k = P_k^- H_k^T \left[ H_k P_k^- H_k^T + R_k \right]^{-1}. \qquad (6)$$

2) Update estimate with measurement $z_k$:

$$\hat{x}_k = \hat{x}_k^- + K_k \left[ z_k - H_k \hat{x}_k^- \right]. \qquad (7)$$

3) Compute error covariance for updated estimate:

$$P_k = \left[ I - K_k H_k \right] P_k^-. \qquad (8)$$

4) Project ahead:

$$\hat{x}_{k+1}^- = \phi_k \hat{x}_k \ ; \text{ and} \qquad (9)$$

$$P_{k+1}^- = \phi_k P_k \phi_k^T. \qquad (10)$$

Some of the terms in equations (6) - (10) include:

$$z_k = \begin{bmatrix} y(L_k) \\ a_1 \end{bmatrix}$$

- measurement of normalized capacity, $y(L_k)$, and slope, $a_1$;

$$x_k = \begin{bmatrix} x_{1k} \\ x_{2k} \end{bmatrix}$$

- state vector at $t_k$; and

$$H_k = \begin{bmatrix} 1 & 0 \\ 0 & 1 \end{bmatrix}$$

- matrix defining the relationship between the measurement and the state vector.

$R_k$ is the covariance matrix of the measurement error, that is, for each observation of the state, $x_k$, there are two

components, the measurement, $z_k$, and an additive error term, $v_k$. The expression used here is $x_k = z_k + v_k$. The covariance matrix of the error is of the form:

$$E\{v_k v_i^T\} = \begin{matrix} R_k, i = k \\ 0, i \neq k \end{matrix} . \qquad (11)$$

The resulting matrix, $R_k$, is

$$R_k = \begin{bmatrix} v_1^2 & 0 \\ 0 & v_2^2 \end{bmatrix} . \qquad (12)$$

The assumption is made above in equation (11) that the measurement error has zero mean (*i.e.*, no fixed bias). The measurement error can now be thought of as a noise term. It may be defined as:

$$v_1 = v_2 = 0.01. \qquad (13)$$

The possible values that are "chosen" may have some support based on past experience. In this case, one might think of the value 0.01 as the uncertainty of a measurement made using a digital meter with a resolution of two digits to the right of the decimal.

It remains to obtain estimates of the error covariance matrix, $P_k$, of the state variable to use for calculating the Kalman gain (equation (6)), the first equation in the loop. One approach is to use whatever knowledge is available about the process, equation (3), prior to entering the Kalman filter loop. The state estimation error may be defined as:

$$e_k^- = x_k - \hat{x}_k^- . \qquad (14)$$

Here, $\hat{x}_k^-$ is the estimate of the state just prior to time $t_k$. The error covariance can be defined as:

$$P_k^- = E\{e_k^- e_k^{-T}\} = E\{(x_k - \hat{x}_k^-)(x_k - x_k^-)^T\} . \qquad (15)$$

Ignoring the noise term $v_k$ for the time being and using just $z_k$, equation (15) becomes:

$$E\left\{ \begin{bmatrix} Y_k^- - \hat{Y}_k^- \\ a_1^- - \hat{a}_1^- \end{bmatrix} \begin{bmatrix} Y_k^- - \hat{Y}_k^- & a_1^- - \hat{a}_1^- \end{bmatrix} \right\} = E\left\{ \begin{bmatrix} (Y_k^- - \hat{Y}_k^-)^2 & (Y_k^- - \hat{Y}_k^-)(a_1^- - \hat{a}_1^-) \\ (Y_k^- - \hat{Y}_k^-)(a_1^- - \hat{a}_1^-) & (a_1^- - \hat{a}_1^-)^2 \end{bmatrix} \right\} \quad (16)$$

To estimate values for each entry in (16) using prior knowledge of the process, consider first the entry:

$$E\{(Y_k^- - \hat{Y}_k^-)^2\}. \qquad (17)$$

Prior to starting the Kalman filter, three measurements of capacity may have been obtained. From these a linear, least squares fit to the data can be calculated. To indicate this is *a priori* knowledge, equation (3) can be rewritten as:

$$\hat{Y}_k^- = \hat{a}_1^-(L_k - L_0) + \hat{a}_0^- , \qquad (18)$$

where the superscript minus signs indicate values prior to starting the Kalman filter (*i.e.,* prior to the next measurement) and $\hat{a}_1^-, \hat{a}_0^-$ are the estimated coefficients.

Given the model above, equation (18), each measurement of capacity satisfies:

$$Y_k^- = \hat{a}_1^-(L_k - L_0) + \hat{a}_0^- + e_k^-, \quad (19)$$

where $e_k^-$ is the error between the data and the model.

Fig. 2 shows the relationships between the model (*i.e.*, fitted line) and the data. The quantity $e_k^-$ is often referred to as the residual. It is considered to have a mean of zero. Returning to equation (17), subtracting equation (18) from equation (19) yields:

$$E\left\{(Y_k^- - \hat{Y}_k^-)^2\right\} = E\left\{e_k^{-2}\right\} = \frac{\sum_k e_k^{-2}}{n - 1} . \quad (20)$$

This is the variance of the residuals, which can be easily obtained from the *a priori* data.

Next is the diagonal term:

$$E\left\{(a_1^- - \hat{a}_1^-)^2\right\} . \quad (21)$$

For the purpose stated above, obtaining starting values for the Kalman filter using prior knowledge of the process, $\hat{a}_1^-$ may be viewed as the true or exact value of the slope, that is, $\mu_{a_1^-} = E\left\{a_1^-\right\} = \hat{a}_1^-$ . Using this in equation (21) yields:

$$E\left\{(a_1^- - \hat{a}_1^-)^2\right\} = E\left\{(a_1^- - \mu_{a_1^-})^2\right\} . \quad (22)$$

This is the variance of the estimate of the slope and is given by:

$$\frac{\sigma^2}{S_{xx}} . \quad (23)$$

This can also be calculated from the prior data.

Quantities to be estimated include the off diagonal entries in equation (16). This is the covariance between the two variables. Using the following reasoning, one might suspect the off diagonal terms are zero. The first term inside the brackets, $Y_k^- - \hat{Y}_k^-$ , is the residual. It has a mean of zero. It has been shown that $\mathrm{cov}(\overline{Y}, a_i) = 0$. For initializing the covariance matrix, the off diagonal entries may be set to zero. This concludes the setup and initialization of the Kalman filter algorithm. The implementation of the filter to estimate the remaining float service life will be described next.

The above discussion provides an algorithm for a Kalman filter and techniques for estimating the quantities for starting the filter. According to some embodiments of the present invention, a Kalman filter is selectively applied for use in predicting the end of the float service life of a battery. In some embodiments, an initial task is to detect the start of the second period of the float service life as shown in Fig. 2, with the Kalman filter being initialized responsive to this period being detected.

Battery capacity may be determined by performing discharges at some interval, which need not be periodic. In some UPS applications, for example, the UPS may intermittently perform a battery test. In such a test, a battery may be discharged for a predetermined portion (*e.g.*, 25%) of an expected discharge time (the time needed to fully discharge the battery). If the battery voltage falls below a specified threshold before reaching the predetermined point, the battery may be deemed to have failed or reached an end of life. An example of such as threshold is 1.83 V/cell.

According to some embodiments of the present invention, this testing may be modified in order to estimate the capacity of the battery. In particular, a test discharge may be conducted to discharge the battery to a particular end voltage to determine capacity, either directly (*e.g.*, in ampere-hours) or indirectly (*e.g.*, in seconds for a standardized discharge current level). At the end of each test discharge, the (calendar) date and time may be stored together with the discharge time. The discharge time can be normalized, for example, by dividing by the reference time chosen for the battery model and discharge performed.

Once a series of discharge tests has been accumulated, a regression model that relates capacity to time (e.g., service time, time on float, calendar time, etc.) may be used to detect whether a marked change in capacity vs. time, *e.g.*, a rapid acceleration in the degradation of battery capacity, has occurred. For example, a least squares fit of a straight line of equation (2) may be used with the variables (L, ln[-ln(1-κ)]) where L is the days in operation (referenced to the first discharge which is arbitrarily set to 0) and κ is the normalized discharge time.

Computations for obtaining the least squares fit are listed below:

$$\text{sumx} = \sum_{i=1}^{3} L_i \ ;$$

$$\text{ssqx} = \sum_{i=1}^{3} L_i^2 \ ;$$

$$\text{sumy} = \sum_{i=1}^{3} \left[ \ln[-\ln(1 - \kappa)] \right];$$

$$\text{ssqy} = \sum_{i=1}^{3} \left[ \ln[-\ln(1 - \kappa)] \right]^2 \ ;$$

$$\text{ssqxy} = \sum_{i=1}^{3} \left[ L_i \left[ \ln[-\ln(1 - \kappa)] \right] \right];$$

$$\text{Sxx} = \text{ssqx} - \frac{\text{sumx}^2}{3} \ ;$$

$$\text{Syy} = \text{ssqy} - \frac{\text{sumy}^2}{3} \ ;$$

and

$$\text{Sxy} = \text{ssqxy} - \frac{(\text{sumx})(\text{sumy})}{3} \ .$$

Using the quantities calculated above, the slope, $a_1$, and y-intercept, $a_0$, and some measures of the quality of the estimate can be obtained:

Slope:

$$\text{Slope:} \qquad a_1 = \frac{\text{sxy}}{\text{sxx}} \ ;$$

Y-Intercept:

$$\text{Y-Intercept:} \quad a_0 = \frac{\text{sumy}}{3} - a_1 \frac{\text{sumx}}{2};$$

Variance: $s^2$ = Syy - $(a_1)$(Sxy)

Correlation Coefficient:

$$r_{xy} = \frac{Sxy}{\sqrt{(Sxx)(Syy)}}$$

With these quantities, a comparison may be made to threshold values to determine whether the battery has reached the stage where capacity starts to decrease rapidly. For example, threshold values indicative of change might include:

slope: $a_1 < 0$;
variance: $s^2 < 0.01$; and
correlation coefficient: $r_{xy} < -0.96$.

If the threshold conditions are not met, then the process may be repeated when the next discharge test is performed. With each new discharge test, the data from the earliest test discharge may be removed and the data from the new discharge test added to maintain three points for the least squares fit and slope detection algorithm. Of course, more than three data points may be used in the regression analysis.

If all three conditions are satisfied, the Kalman filter may be initialized and started. The error covariance matrix in equation (15), $P_k^-$, and the measurement error covariance in equation (12), $R_k$, may be initialized to obtain the Kalman gain, equation (6). Here:

$$P_k^- = \begin{bmatrix} s^2 & 0 \\ 0 & \dfrac{s^2}{Sxx} \end{bmatrix}; \qquad\qquad (24)$$

and

$$R_k = \begin{bmatrix} 0.01^2 & 0 \\ 0 & 0.01^2 \end{bmatrix}. \qquad\qquad (25)$$

The initial value of the state vector, $\hat{x}_k^-$, can be set using the results from the last test discharge when the three conditions on the slope were satisfied. A graphical depiction of initializing and starting the Kalman filter is provided in Fig. 3.

In this implementation of a Kalman filter, once the filter is started, the threshold time, to, may be subtracted from the calendar time in all subsequent calculations. Time then may be determined, for example, as hours since the degradation of capacity was detected. The Kalman filter loop, as described in equations (6) - (10), may now be applied to the data from the most recent test discharge.

According to some embodiments of the present invention, applications of such a filter may include obtaining a filtered estimate of the battery capacity after each test discharge is performed and to project ahead to determine the remaining time until the battery reaches end of life. The filtered capacity or estimate of capacity may be generated from equation (7). The error covariance matrix of equation (8) can be used to judge the quality of the estimate. The project ahead step in equations (9) and (10) can be used to estimate the remaining life of the battery.

Referring to equation (5), where the elements of the state transition matrix are shown, the $\Delta t$ entry is the time between the current or most recently performed test discharge and the next scheduled one. This step, equations (9) and (10), could be executed when the next test discharge is performed. To obtain an estimate of the life remaining, a suitable time interval, $\Delta t$, of interest may be chosen and an estimate of the state vector may be computed using equation (9) and the error covariance of equation (10). The error covariance matrix, also projected ahead, can be used to judge the quality of the estimates.

**Exemplary Implementations**

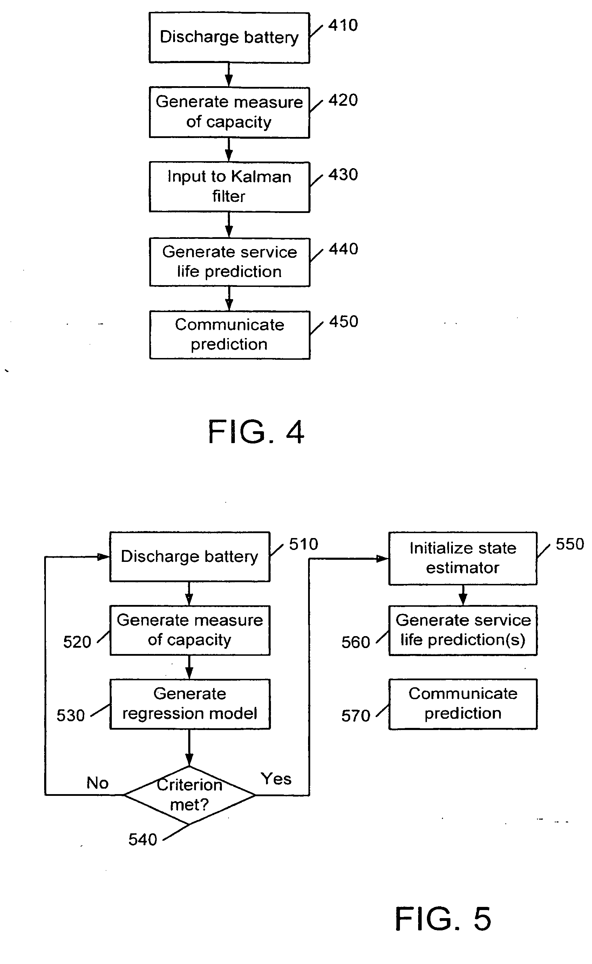

FIG. 4 illustrates exemplary operations for generating a prediction of service life of a battery according to some embodiments of the present invention. The battery is discharged (block 410) and, responsive to the discharge, a measure of battery capacity is generated (block 420). For example, the battery may be test discharged to a predetermined end voltage as described above, with the time required to reach the end voltage representing a measure of battery capacity. The generated measure of battery capacity is used as an input to a Kalman filter (block 430), which may be used to generate a prediction of battery service life (block 440). For example, the measure of battery capacity may be used to establish an initial or other state input into the Kalman filter, along lines discussed above. The prediction of service life may then be communicated, *e.g.*, displayed to a user or input to another process, such as an automated facilities management program (block 450).

FIG. 5 illustrates exemplary operations for prediction of service life of a battery according to further aspects of the present invention. The battery is discharged (block 510) and, responsive to the discharge, a measure of battery capacity is generated (block 520). The measure of battery capacity is used to generate a regression model that relates battery capacity to time (e.g., service time, time on float, calendar time, etc.) (block 530). If the regression model does not meet a predetermined criterion indicative of, for example, an acceleration of battery capacity degradation (block 540), a subsequent discharge is performed (block 510) and a new regression model generated (block 530). If the regression model does meet the predetermined criterion (block 540), a predictive state estimator that is configured to predict battery service life is initialized using, for example, initial conditions generated by the regression model (block 550). The state estimator is then used to generate a prediction of service life (block 560), which may be communicated, for example, displayed to a user or input to another process (block 570).

It will be appreciated that the regression model may be along the lines of the straight-line model described above, or may take some other form. For example, in applications other than VRLA service life estimation, the regression model may be tailored to allow recognition of some other data pattern or feature that is indicative of a transition to a portion of a battery's service life for which the state estimation described is applicable. The state estimator may take the form of a Kalman filter along the lines described above, or may utilize some other form of deterministic, probabilistic and/or adaptive model.

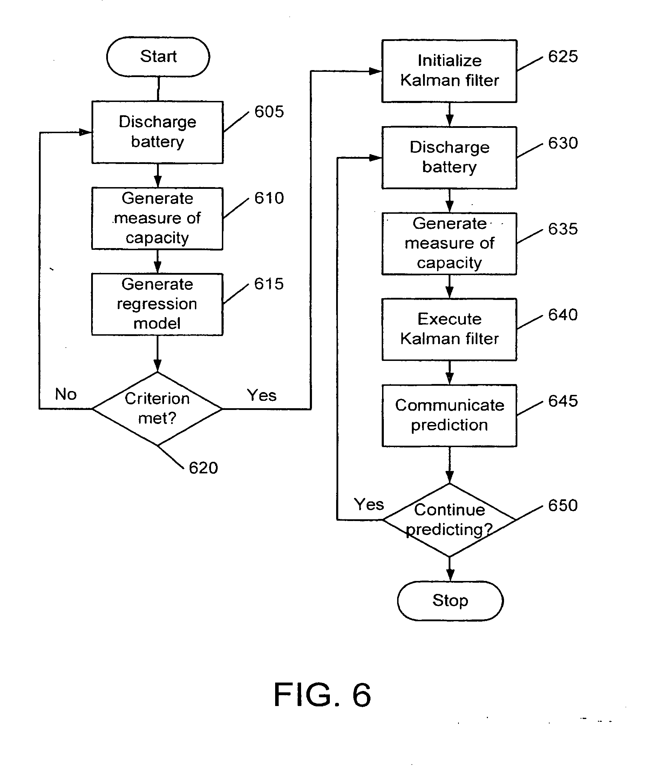

FIG. 6 illustrates operations according to further embodiments that combine aspects along the lines of FIGs. 4 and 5. Responsive to respective ones of a series of discharges of a battery (block 605), respective measures of battery capacity are generated (block 610) and used to generate a succession of regression models (block 615), *e.g.*, using the straight-line curve fitting described above. Responsive to detecting a regression model that meets a predetermined criterion, *e.g.*, a straight-line regression model meeting predetermined slope, variance and correlation coefficient criteria indicative of an acceleration of battery capacity degradation associated with the battery transitioning into a portion of its service life in which it exhibits a higher - rate of degradation (block 620), a Kalman filter configured to estimate the battery state in this enhanced degradation portion of the battery's service life is initialized using, for example, initial conditions generated according to the regression model (block 625). Subsequent to initialization of the Kalman filter, an additional discharge may be performed (block 630) to generate a new measure of battery capacity (block 635) that serves as an input to the Kalman filter, which executes to generate a prediction of battery service life, *e.g.*, in a predict-ahead step as outlined above (block 640). The prediction of service life may be communicated, e.g., displayed to a user or input to another process (block 645). Additional predictions may be generated responsive to subsequent discharges (block 630) by iteratively generating measures of battery capacity (block 636) and responsively executing the Kalman filter using these measures as an input (block 640).

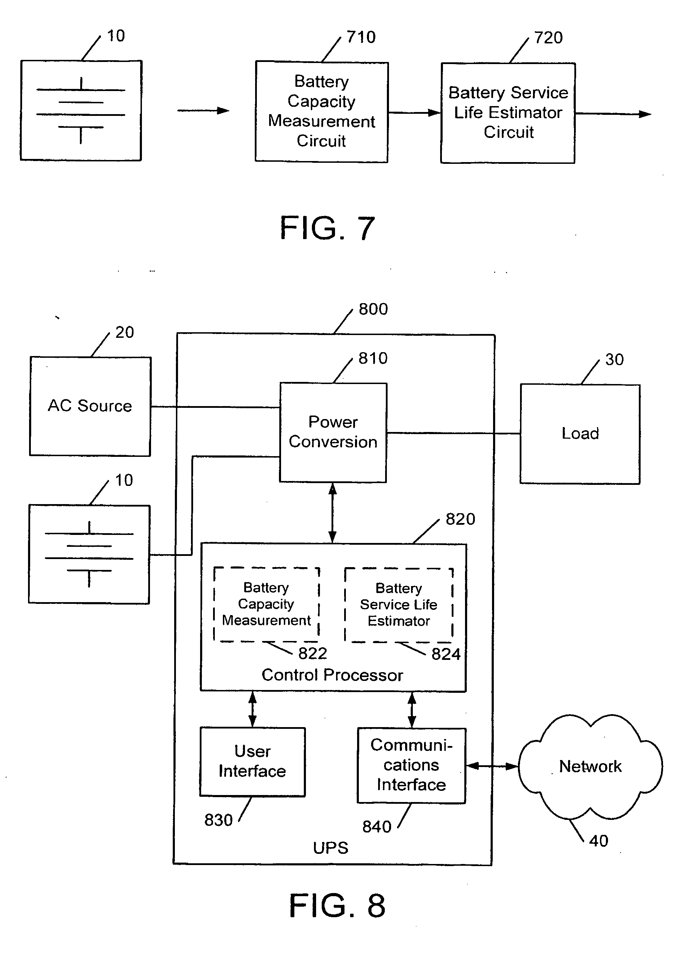

FIG. 7 illustrates apparatus for predicting battery service life according to further embodiments of the present invention. A battery capacity measurement circuit 710 is responsive to discharges of a battery 10, producing measures of battery capacity to a battery service life estimator circuit 720. The battery service life estimator circuit 720 generates predictions of battery service life responsive to the measures of battery capacity using , for example, various operations illustrated in FIGs. 4-6.

It will be appreciated that, in general, the battery capacity measurement circuit 710 and the battery service life estimator circuit 720 may be implemented using analog circuitry and/or digital circuitry, including, but not limited to, data processing circuitry, such as a microcontroller or microprocessor. It will be further appreciated that the battery capacity measurement circuit 710 and/or the battery service life estimator circuit 720 may be integrated in devices or systems that utilize or otherwise interact with the battery 10, such as a UPS or a standalone battery charger. In some embodiments, all or portions of the battery capacity measurement circuit 710 and/or the battery service life estimator circuit 720 may be implemented in a computer or other data processing device that is electrically coupled to such a device or system.

FIG. 8 illustrates an exemplary implementation in a UPS 800 according to some embodiments of the present invention. The UPS 800 includes power conversion circuitry 810 (*e.g.*, rectifier, inverter, etc.) that is configured to be coupled to an AC source 20 (*e.g.*, a utility) and to a battery 10, and that selectively provides power from the AC source 20 and the battery 10 to a load 30. The power conversion circuitry 810 may further include battery charger circuitry that is configured to charge the battery 10 from the AC source 20 to maintain the battery 10 in float service. The UPS 800 further includes a control processor 820, *e.g.*, a microprocessor or microcontroller and associated memory, which is operatively associated with the power conversion circuitry 810 and controls operations thereof. The control processor 820 may also be operatively associated with user interface circuitry 830, e.g., a display, keyboard, and with communications interface circuitry 840, which may provide a communications interface with a network 40 to support communications with other devices.

As further shown, the control processor 820 may be configured, e.g., via software and/or firmware, such that it serves as a battery capacity measurement circuit 822 and a battery service life estimator circuit 824. For example, the battery capacity measurement circuit 822 may be configured to cause a test discharge of the battery 10 via the power conversion circuitry 810 under predetermined conditions as described above, and to responsively generate a measure of capacity of the battery 10. The measure of battery capacity thus generated may be used as an input to the battery service life estimator circuit 824. The battery service life estimator circuit 824 may use operations along the lines of those described with reference to FIGs. 4-6 to generate a prediction of service life of the battery 10. The control processor 820 may communicate the prediction to the user interface circuitry 830, which may display the prediction. Alternatively or in addition to communication to the user interface circuitry 830, the control processor 820 may communicate the prediction to another device via the communications interface circuit 840 and network 40.

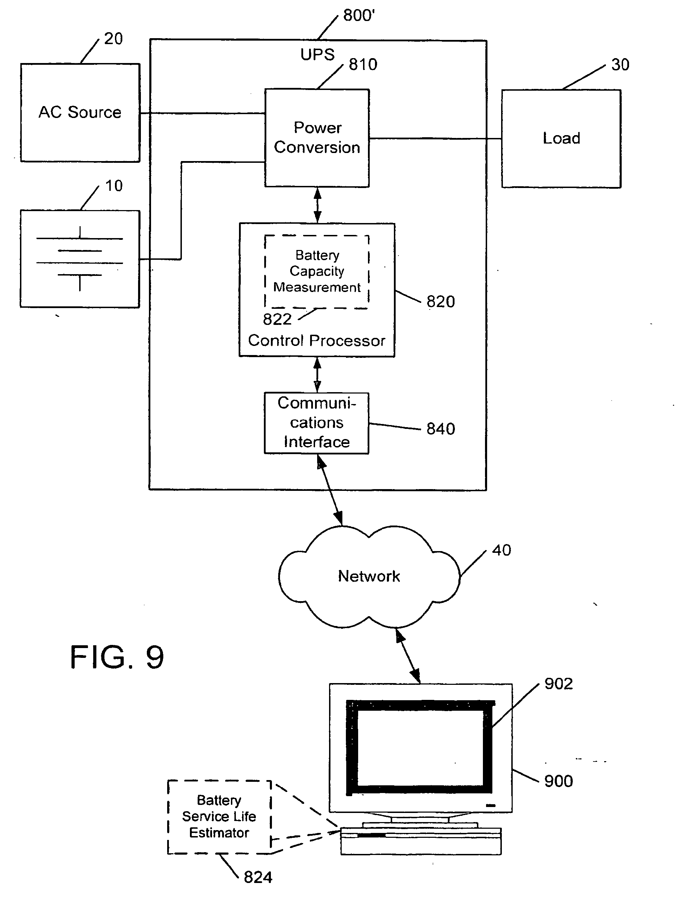

FIG. 9 illustrates another implementation according to further embodiments of the present invention in which battery capacity measurement and battery service life estimation functions are distributed among multiple devices. A UPS 800' that receives power for a load 30 from an AC source 20 and a battery 10 includes power conversion circuitry 810 along the lines discussed above with reference to FIG. 8. In this case, however, the UPS 800' includes a control processor 820 that is configured to provide a battery capacity measurement circuit 822 that generates measures of battery capacity that are communicated outside of the UPS 800' over a network 40 via a communications interface circuit 840 of the UPS 800'.

A computer 900 or other data processing device may be configured to provide a battery service life estimator circuit 824, which receives the battery capacity measures transmitted over the network 40 by the UPS 800' and responsively generates predictions of battery service life. The predications of service life may be communicated, for example, displayed on a display 902 of the computer 900, communicated to another process executing on the computer 900 and/or communicated to some other device over the network 40. The battery service life estimator circuit 824 may be further configured to control operations of the battery capacity measurement circuit 822 via the network 40. For example, the battery service life estimator circuit 824 may send commands to the battery capacity measurement circuit 822 via the network 40 to cause test discharges of the battery 10 at particular times for purposes of generating capacity measures used in generating service life predictions.

It will be understood that the implementations shown in FIGs. 8 and 9 are provided for purposes of illustration, and that further embodiments of the present invention may be implemented using other arrangements. For example, battery capacity measurement and battery service life estimator circuitry could be implemented in a standalone battery charger or a standalone battery monitoring device in a manner similar to the implementation in a UPS 800 as illustrated in FIG. 8. Such devices could also be network with a control computer or other networked device in a manner similar to that described above with reference to FIG. 9.

In the drawings and specification, there have been disclosed exemplary embodiments of the invention. Although specific terms are employed, they are used in a generic and descriptive sense only and not for purposes of limitation, the scope of the invention being defined by the following claims.

**Claims**

1.   A method of estimating service life of a battery, the method comprising the following steps implemented in a computer:

   generating (610) a set of measures of capacity of the battery using a series of discharges of the battery; and
   generating (615) a regression model that relates battery capacity to time based on the set of measures of battery capacity;
   initializing (625) a Kalman filter responsive to the regression model meeting a predetermined criterion; and
   generating (630-645) a prediction of service life from the set of measures of capacity using the Kalman filter..

2.   The method of Claim 1, wherein initializing (625) the Kalman filter responsive to the regression model meeting a predetermined criterion comprises initializing the Kalman filter with an initial condition generated from the regression model.

3.   The method of Claim 1, wherein generating (610) a set of measures of capacity of the battery using a series of discharges of the battery comprises:

> determining a time required to discharge the battery to a predetermined voltage; and
> generating a measure of capacity based on the determined discharge time.

4. The method of Claim 1, wherein initializing (625) the Kalman filter responsive to the regression model meeting a predetermined criterion is preceded by detecting an acceleration of a decrease in battery capacity and wherein initializing a Kalman filter responsive to the regression model meeting a predetermined criterion comprises initializing the Kalman filter responsive to the detected acceleration of decrease in battery capacity.

5. An apparatus (710, 720) configured to perform the method of any of Claims 1 through 4.

6. The apparatus of Claim 5, comprising:

> an uninterruptible power supply, UPS (800) configured to be coupled to the battery and to charge and discharge the battery; and
> a battery capacity measurement circuit (822) configured to generate the set of measures of capacity of the battery responsive to a series of discharges of the battery by the UPS circuit.

7. A computer-readable medium having computer program code embodied therein, the computer program code comprising program code configured to perform the method of any of Claims 1 through 4.


**Patentansprüche**

1. Ein Verfahren zum Schätzen einer Batterielebensdauer, wobei das Verfahren folgende Schritte aufweist, die in einem Computer implementiert sind:

> Generieren (610) eines Satzes von Messungen einer Kapazität der Batterie unter Verwendung einer Reihe von Entladungen der Batterie; und
> Generieren (615) eines Regressionsmodells, das die Kapazität der Batterie mit der Zeit in Beziehung setzt, und zwar basierend auf dem Satz von Messungen der Batteriekapazität;
> Initialisieren (625) eines Kaiman-Filters ansprechend darauf, dass das Regressionsmodell ein vorbestimmtes Kriterium erfüllt; und
> Generieren (630-645) einer Vorhersage einer Lebensdauer aus dem Satz von Messungen der Kapazität unter Verwendung des Kalman-Filters.

2. Verfahren nach Anspruch 1, wobei das Initialisieren (625) des Kaiman-Filters ansprechend darauf, dass das Regressionsmodell ein vorbestimmtes Kriterium erfüllt, das Initialisieren des Kalman-Filters mit einem anfänglichen Zustand aufweist, der von dem Regressionsmodell generiert worden ist.

3. Verfahren nach Anspruch 1, wobei das Generieren (610) eines Satzes von Messungen der Kapazität der Batterie unter Verwendung einer Reihe von Entladungen der Batterie Folgendes aufweist:

> Bestimmen einer Zeit, die erforderlich ist, um die Batterie auf eine vorbestimmte Spannung zu entladen; und
> Generieren einer Messung der Kapazität basierend auf der bestimmten Entladezeit.

4. Verfahren nach Anspruch 1, wobei dem Initialisieren (625) des Kalman-Filters ansprechend darauf, dass das Regressionsmodell ein vorbestimmtes Kriterium erfüllt, das Detektieren einer Beschleunigung einer Verringerung der Batteriekapazität vorausgeht, und wobei das Initialisieren eines Kalman-Filters ansprechend darauf, dass das Regressionsmodell ein vorbestimmtes Kriterium erfüllt, das Initialisieren des Kalman-Filters ansprechend auf die detektierte Beschleunigung der Verringerung der Batterielebensdauer aufweist.

5. Vorrichtung (710, 720), die konfiguriert ist, um das Verfahren nach einem der Ansprüche 1 bis 4 durchzuführen.

6. Vorrichtung nach Anspruch 5, die Folgendes aufweist:

> eine unterbrechungsfreie Stromversorgung bzw. UPS (UPS = uninterruptible power supply) (800), die konfiguriert ist, um an die Batterie gekoppelt zu werden und zum Laden und Entladen der Batterie; und
eine Batteriekapazitätsmessschaltung (822), die konfiguriert ist, den Satz von Messungen der Kapazität der Batterie ansprechend auf eine Reihe von Entladungen der Batterie durch die UPS-Schaltung zu generieren.

**7.** Ein computerlesbares Medium mit darin enthaltenem Computerprogrammcode, wobei der Computerprogrammcode Programmcode aufweist, der konfiguriert ist, das Verfahren nach einem der Ansprüche 1 bis 4 durchzuführen.

**Revendications**

**1.** Procédé pour estimer la durée de vie d'une batterie, le procédé comprenant les étapes suivantes mises en oeuvre dans un ordinateur :

générer (610) un ensemble de mesures de capacité de la batterie en utilisant une série de décharges de la batterie ; et
générer (615) un modèle de régression qui relie la capacité de la batterie au temps sur la base de l'ensemble de mesures de capacité de batterie ;
initialiser (625) un filtre de Kalman en réponse au fait que le modèle de régression satisfait un critère prédéterminé ; et
générer (630-645) une prédiction de durée de vie à partir de l'ensemble de mesures de capacité en utilisant le filtre de Kalman.

**2.** Procédé selon la revendication 1, dans lequel l'initialisation (625) du filtre de Kalman en réponse au fait que le modèle de régression satisfait un critère prédéterminé comprend l'initialisation du filtre de Kalman avec une condition initiale générée à partir du modèle de régression.

**3.** Procédé selon la revendication 1, dans lequel la génération (610) d'un ensemble de mesures de capacité de la batterie en utilisant une série de décharges de la batterie comprend :

déterminer le temps nécessaire pour décharger la batterie jusqu'à une tension prédéterminée ; et
générer une mesure de capacité sur la base du temps de décharge déterminé.

**4.** Procédé selon la revendication 1, dans lequel l'initialisation (625) du filtre de Kalman en réponse au fait que le modèle de régression satisfait un critère prédéterminé est précédée de la détection d'une accélération de la diminution de la capacité de la batterie, et dans lequel l'initialisation d'un filtre de Kalman en réponse au fait que le modèle de régression satisfait un critère prédéterminé comprend l'initialisation du filtre de Kalman en réponse à l'accélération détectée de la diminution de la capacité de la batterie.

**5.** Appareil (710, 720) agencé pour réaliser le procédé de l'une quelconque des revendications 1 à 4.

**6.** Appareil selon la revendication 5, comprenant :

une alimentation ininterruptible, UPS, (800) agencée pour être couplée à la batterie et pour charger et décharger la batterie ; et
un circuit de mesure de capacité de batterie (822) agencé pour générer l'ensemble de mesures de capacité de la batterie en réponse à une série de décharges de la batterie par le circuit UPS.

**7.** Support lisible par un ordinateur comprenant du code de programme d'ordinateur incorporé, le code de programme d'ordinateur comprenant du code de programme agencé pour réaliser le procédé de l'une quelconque des revendications 1 à 4.

RELATIVE
CAPACITY

TIME

## FIG. 1

$Y_k^-$

$e_k^-$

$\hat{Y}_k^-$

$t_0$        $t_k^-$        $t_k$

## FIG. 2

Conditions satisfied for slope,
variance, correlation coefficient

Initialize Kalman filter here

Start Kalman filter
Measure new slope and capacity

$t_0$

## FIG. 3

Discharge battery — 410

Generate measure of capacity — 420

Input to Kalman filter — 430

Generate service life prediction — 440

Communicate prediction — 450

# FIG. 4

Discharge battery — 510

Generate measure of capacity — 520

Generate regression model — 530

Criterion met? — 540

No

Yes

Initialize state estimator — 550

Generate service life prediction(s) — 560

Communicate prediction — 570

# FIG. 5

FIG. 6

10

710

Battery
Capacity
Measurement
Circuit

720

Battery Service
Life Estimator
Circuit

# FIG. 7

800

20

AC Source

810

Power
Conversion

30

Load

10

820

Control Processor

Battery
Capacity
Measurement

822

Battery
Service Life
Estimator

824

User
Interface

830

Communi-
cations
Interface

840

Network

40

UPS

# FIG. 8

EP 2 098 878 B1

FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6924622 B, Anbuky
- US 7199557 B, Anbuky
- US 2002130637 A1

**Non-patent literature cited in the description**

- **WEBB L. BURGESS.** An analysis of float service life test data of VRLA batteries. *Journal of Power Sources,* 1998, vol. 75, 28-35